# EUROPEAN PATENT APPLICATION

(11) **EP 1 816 682 A2**
(43) Date of publication of application: **08.08.2007**
(21) Application number: 07101747.9
(22) Date of filing: 05.02.2007
(51) Int. Cl.: H01L 29/24, H01L 29/861

(54) **Phase change RAM including resistance element having diode function and methods of fabricating and operating the same**

(30) Priority: 07.02.2006 KR 20060011830
(71) Applicant: Samsung Electronics Co., Ltd., Suwon-si, Gyeonggi-Do (KR)
(72) Inventor: Kim, Ki-joon, Gyeonggi-do (KR); Khang, Yoon-ho, Gyeonggi-do (KR); Noh, Jin-seo, Gyeonggi-do (KR)
(74) Representative: Greene, Simon Kenneth

(57) **Abstract**

A phase change RAM (PRAM) including a resistance element having a diode function, and methods of fabricating and operating the same are provided. The PRAM comprises a substrate (40); a phase change diode layer (48) formed on the substrate; and an upper electrode (50) formed on the phase change diode layer. The phase change diode layer comprises a material layer doped with first impurities, and a phase change layer which is stacked on the doped layer. The phase change layer shows a characteristic of a semiconductor material doped with impurities having an opposite conductive type to that of the first impurities.

## Description

### BACKGROUND OF THE INVENTION

The present invention relates to a semiconductor memory device, and more particularly, to a phase change RAM including a phase change resistance element having diode function, and methods of fabricating and operating the same.

A recent memory device is focused on a non-volatile memory device having advantages of a DRAM. As information technology is developed, and various equipment and contents are developed in order to meet the needs for the development of information technology, a demand of non-volatile memory devices rapidly increases. To satisfy the market changes, various non-volatile memory devices have been introduced after typical flash or SONOS memory devices.

One of the non-volatile memory devices, which are used at present, and are prepared to enter the markets, a phase change RAM (PRAM) is placed in lead along with a magnetic RAM (MRAM), a ferroelectric RAM (FRAM), and a resistance RAM (RRAM). The unit cell of an PRAM comprises one resistance element composed of a phase change material, and one transistor flowing a current to the resistance element or cutting off the current, but recently, there has been introduced a PRAM in which the transistor is replaced with a diode, that is, including one resistance element and one diode in order to increase an integration density.

However, while the PRAM, which has been introduced up to now (hereinafter, conventional PRAM), improves many defects of the conventional memory device, it is necessary to modify the structure of the PRAM capable of further simplifying fabrication processes of the conventional PRAM and increasing an integration density thereof when considering the speed of the current technology development of industries.

### SUMMARY OF THE INVENTION

The present invention provides a phase change RAM (PRAM) having a more simplified structure capable of simplifying fabrication processes of the PRAM and increasing an integration density thereof.

The present invention also provides a method of operating the PRAM.

The present invention also provides a method of fabricating the PRAM.

According to an embodiment of the present invention, there is provided a PRAM comprising: a substrate; a phase change diode layer formed on the substrate; and an upper electrode formed on the phase change diode layer.

The phase change diode layer may comprise a material layer doped with first impurities, and a phase change layer, which are sequentially stacked, wherein the phase change layer shows characteristics of a semiconductor material doped with impurities having an opposite conductive type to that of the first impurities. At this time, the first impurities may be n-type impurities, and the phase change layer may be composed of a phase change material showing a p-type semiconductor material characteristic.

According to an aspect, the PRAM further comprises a word line disposed between the phase change diode layer and the substrate, and a bit line disposed on the upper electrode to contact the upper electrode and to cross the word line.

According to another aspect, the PRAM furtheer comprises a word line disposed on the substrate spaced from the phase change diode layer, and a bit line disposed on the upper electrode to contact the upper electrode and to cross the word line.

A width of the phase change layer may be equal to or greater than a width of the material layer doped with first impurities.

According to other embodiment of the present invention, the phase change diode layer may comprise a phase change layer and a material layer doped with first impurities, which are sequentially stacked, in which the phase change layer is composed of a phase change material showing a characteristic of a semiconductor material doped with impurities having an opposite conductive type to that of the first impurities. At this time, the first impurities may be n-type impurities, and the phase change layer may be composed of a phase change material showing a p-type semiconductor material characteristic.

The substrate may be an n-type or a p-type semiconductor substrate, and may be a non-semiconductor substrate.

According to other embodiment of the present invention, the first impurities may be p-type impurities, and the phase change layer may be composed of a phase change material showing a n-type semiconductor material characteristic.

According to another aspect of the present invention, there is provided a method of operating a PRAM having a phase change diode layer between a substrate and an interconnection, and the method comprises applying a current passing the phase change diode layer between the substrate and the interconnection in a forward direction.

In the operating method, the applying of the current comprises applying one from the group consisting of a write current, a read current, and an erase current.

Further, the applying of the read current may further comprise applying the read current to measure a resistance of the phase change diode layer, and comparing the measured resistance to a reference resistance.

According to another aspect of the present invention, there is provided a method of fabricating a PRAM comprising: forming a first interconnection on a substrate doped with first impurities; forming a first insulating interlayer on the substrate, to cover the first interconnection; forming a contact hole in the first insulating interlayer to expose a predetermined portion of the substrate spaced from the first interconnection; filling the contact hole with a material layer doped with first impurities; sequentially stacking a phase change layer and an upper electrode on the first insulating interlayer to cover the doped material layer, the phase change layer showing semiconductor characteristic opposite to that of the doped material layer; and forming a second interconnection connected to the upper electrode and crossing the first interconnection.

The sequentially stacking of a phase change layer and an upper electrode may comprise: forming a second insulating interlayer on the first insulating interlayer, to cover the doped material layer; forming a photoresistive layer pattern on the second insulating interlayer defining a portion where the phase change layer is formed; forming a via hole exposing the doped material layer in the second insulating interlayer, using the photoresistive layer pattern as a mask; sequentially stacking the phase change layer and the upper electrode in the via hole; and removing the photoresistive layer pattern.

Further, the first impurities may be n-type impurities, and the phase change layer may be composed of a phase change material showing p-type semiconductor material characteristics.

According to another aspect of the present invention, there is provided a method of fabricating a PRAM comprising: forming a first interconnection on a substrate doped with first impurities; forming an insulating interlayer on the substrate, to cover the first interconnection; forming a contact hole in the insulating interlayer, to expose a predetermined portion of the substrate spaced from the first interconnection; sequentially stacking a material layer doped with the first impurities, a phase change layer showing semiconductor characteristics opposite to that of the doped material layer, and an upper electrode in the contact hole; and forming a second interconnection on the insulating interlayer, the second interconnection connected to the upper electrode and crossing the first interconnection.

In the fabricating method, the first impurities may be n-type impurities, and the phase change layer may be composed of a phase change material showing a p-type semiconductor material characteristic. The material layer doped with the first impurities, and the phase change layer may be formed using different methods, and the material layer doped with the first impurities may be formed using a selective epitaxial growth method.

According to another aspect of the present invention, there is provided a method of fabricating a PRAM comprising: forming a first interconnection on a substrate doped with first impurities; forming an insulating interlayer on the substrate, to cover the first interconnection; forming a contact hole in the insulating interlayer, to expose a portion of the substrate spaced from the first interconnection; sequentially forming a phase change layer and a material layer doped with second impurities having a conductivity type opposite to that of the first impurities, in the contact hole; and forming a second interconnection connected to the doped material layer and crossing the first interconnection, on the insulating interlayer, wherein the phase change layer is composed of a phase change material showing semiconductor characteristics opposite to that of the substrate.

In the fabricating method, the first interconnection may be formed to be buried or embossed on the substrate.

According to another aspect of the present invention, there is provided a method of fabricating a PRAM comprising: forming a first interconnection on a substrate doped with first impurities; forming an insulating interlayer on the substrate, to cover the first interconnection; forming a contact hole in the insulating interlayer, to expose a portion of the substrate spaced from the first interconnection; sequentially forming a phase change layer and a material layer doped with second impurities having a conductivity type opposite to that of the first impurities, in the contact hole; and forming a second interconnection connected to the doped material layer and crossing the first interconnection, on the insulating interlayer, wherein the phase change layer is composed of a phase change material showing the same semiconductor characteristics as that of the substrate.

In the fabricating method, a conductive layer may be further formed between the substrate and the phase change layer.

Further, the method may further comprise forming a conductive plug between the first interconnection and the substrate.

### BRIEF DESCRIPTION OF THE DRAWINGS

The above and other features and advantages of the present invention will become more apparent by describing in detail exemplary embodiments thereof with reference to the attached drawings in which:
FIG. 1 is an equivalent circuit of a phase change RAM (PRAM) according to an embodiment of the present invention;
FIGS. 2A and 2B are sectional views illustrating a structure of the PRAM having the equivalent circuit of FIG. 1 according to a first embodiment of the present invention;
FIG. 3 is a sectional view illustrating a structure of the PRAM having the equivalent circuit of FIG. 1 according to a second embodiment of the present invention;
FIG. 4 is a sectional view illustrating a structure of the PRAM having the equivalent circuit of FIG. 1 according to a third embodiment of the present invention;
FIGS. 5A and 5B are sectional views illustrating structures of PRAMs employing technical characteristics of the PRAM of FIG. 4 to the PRAM of FIG. 2;
FIG. 6 is a sectional view illustrating a structure of a PRAM having the equivalent circuit of FIG. 1 according to a fourth embodiment of the present invention;
FIG. 7 is a three-dimensional view illustrating that the first interconnection functioning as a bit line in the PRAM of FIG. 6 is formed in the substrate with a recessed shape;
FIG. 8 is a three-dimensional view illustrating that the first interconnection functioning as a bit line in the PRAM of FIG. 6 is formed in the substrate with a raised shape;
FIG. 9 is a sectional view illustrating that the conductive layer, the phase change layer and the conductive plug in the PRAM of FIG. 6 all have a same diameter;
FIG. 10 illustrates plots of current-voltage characteristics measured with respect to four specimens to verify that the lower electrode contact layer and the phase change layer in the PRAM according to embodiments of the present invention show P-N junction diode characteristics;
FIG. 11 illustrates a current-voltage characteristic measured with respect to the specimen whose phase change layer is removed;
FIGS. 12 through 15 are sectional views to explain a method of operating a PRAM according to an embodiment of the present invention in accordance with processing sequences;
FIGS. 16 through 22 are sectional views to explain a method of fabricating the PRAM of FIG. 3 in accordance with processing sequences; and
FIGS. 23 through 26 are sectional views to explain a method of fabricating the PRAM of FIG. 4 in accordance with processing sequences.

### DETAILED DESCRIPTION OF THE INVENTION

Hereinafter, a phase change RAM including a phase change resistance element having a diode function, and methods of fabricating and operating the same according to an embodiment of the present invention will be explained in detail with reference to the accompanying drawings. In the drawings, the thicknesses of layers and regions are exaggerated for clarity.

First, a phase change RAM according to an embodiment of the present invention will be explained.

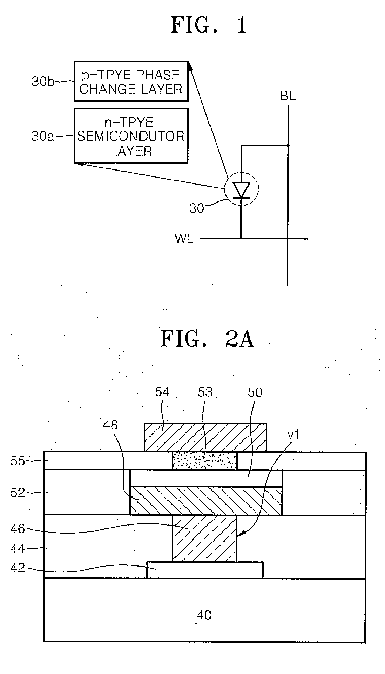

FIG. 1 illustrates an equivalent circuit of a phase change RAM (PRAM) according to an embodiment of the present invention.

Referring to FIG. 1, a PRAM according to an embodiment of the present invention includes one phase change diode 30. The phase change diode 30 includes an n-type semiconductor layer 30a and a p-type phase change layer 30b, and is a diode showing the same current-voltage characteristics as that of a typical PN junction diode. The n-type semiconductor layer 30a and the p-type phase change layer 30b are sequentially stacked in the phase change diode 30. The p-type phase change layer 30b of the phase change diode 30 is connected to a bit line BL. The n-type semiconductor layer 30a is connected to a word line WL. The n-type semiconductor layer 30a may be, for example, a silicon layer doped with n-type impurities. Further, the p-type phase change layer 30b may be a chemical layer including, for example, tellurium (Te) showing p-type semiconductor characteristics as itself. The chemical layer including tellurium may be a Ge-Sb-Te layer, a Te-Ge-Sn-Au layer, a Bi-Sb-Te layer, a Bi-Sb-Te-Se layer, an In-Sb-Te layer, or a Sb-Se layer. The Ge-Sb-Te layer may be, for example, a Ge₂Sb₂Te₅ layer or a GeSb₂Te₄ layer. The Bi-Sb-Te-Se layer may be, for example, Sb₂Te₃-Bi₂Se₃ layer. Further, the In-Sb-Te layer may be an In₃SbTe₂ layer. Further, the Sb-Se layer may be, for example, a Sb₂Se layer.

FIG. 2A illustrates a structure of the PRAM having the equivalent circuit of FIG. 1 according to a first embodiment of the present invention.

Referring to FIG. 2A, a first interconnection 42 is formed on a predetermined portion of a substrate 40. The substrate 40 may be a typical semiconductor substrate or an SOI substrate, or a nonconductive substrate. The first interconnection 42 is a conductive interconnection, and is used as a lower electrode and a word line as well. A first insulating interlayer 44 having a via hole v1 exposing the first interconnection 42 is formed on the substrate 40. The via hole v1 is filled with a conductive plug 46. The conductive plug 46 is a lower electrode contact plug, and is preferably formed of an n-type semiconductor. Thus, the conductive plug 46 corresponds to the n-type semiconductor layer 30a of FIG. 1. A phase change layer 48 and an upper electrode 50 are sequentially stacked on the first insulating interlayer 44, to cover the conductive plug 46. The phase change layer 48 may be composed of a material having the same characteristics as that of a p-type semiconductor, and may be, for example, a GST layer. The upper electrode 50 may be any one selected from the group consisting of Ti-N, Ti-Al-N, W-N, Ti-W, Ti-Te electrodes, or may be formed of at least two electrodes thereof. The phase change layer 48 and the upper electrode 50 are surrounded by a second insulating interlayer 52. The second insulating interlayer 52 may be composed of the same material as that of the first insulating interlayer 44 disposed therebelow. An upper electrode contact plug 53 is disposed on the upper electrode 50, and the upper electrode contact plug 53 is surrounded by a third insulating interlayer 55. The third insulating interlayer 55 may be composed of a material identical to or different from that of the second insulating interlayer 52. A second interconnection 54 is disposed on the third insulating interlayer 55 to cover the upper electrode contact plug 53. The second interconnection 54 may be disposed in the direction crossing or in parallel with the first interconnection 42. The second interconnection 54 may be a bit line.

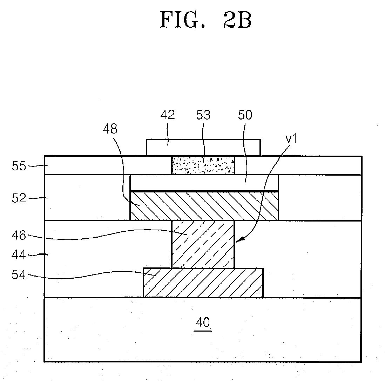

In the meantime, the positions of the first and second interconnections 42 and 55 may be changed as shown in FIG. 2B. The first interconnection 42 may be disposed on the third insulating interlayer 55, to cover the upper electrode contact plug 53. The second interconnection 55 may be disposed between the substrate 40 and the conductive plug 46. In the case of FIG. 2B, the first and second interconnections 42 and 54 may cross to each other, or may be disposed in parallel with each other.

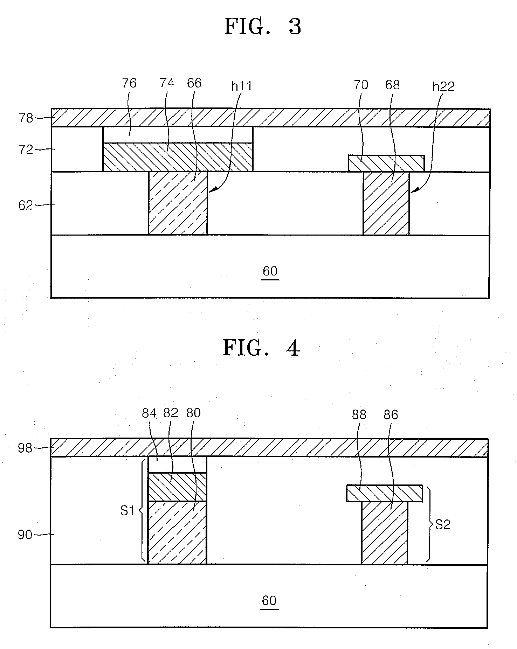

FIG. 3 illustrates a structure of the PRAM having the equivalent circuit of FIG. 1 according to a second embodiment of the present invention.

Referring to FIG. 3, a first insulating interlayer 62 is formed on a substrate 60. The substrate 60 may be, for example, an n-type semiconductor substrate. First and second contact holes h11 and h22 are formed in the first insulating interlayer 62, to respectively expose different portions of the substrate 60. The first contact hole h11 is filled with a first conductive plug 66, and the second contact hole h22 is filled with a second conductive plug 68. The first and second conductive plugs 66 and 68 may be composed of different materials. For example, the first conductive plug 66 may be composed of the same semiconductor material as that of the substrate 60, for example, a plug composed of n-type silicon. At this time, doped densities of the substrate 60 and the first conductive plug 66 may be different. Also, the second conductive plug 68 may be a metal plug. Also, the second conductive plug 68 may be a plug composed of the same polarality of semiconductor as that of the substrate 60. A first interconnection 70 and a phase change layer 74 are separately disposed on the first insulating interlayer 62. An upper electrode 76 is formed on the phase change layer 74. The upper electrode 76 may be any one selected from the group of Ti-N, Ti-Al-N, W-N, Ti-W, Ti-Te electrodes, or may be composed of at least two electrodes thereof. The first interconnection 70 contacts the second conductive plug 68. The first interconnection 70 functions as a word line, and may be composed of the same material as that of the first interconnection 42 of FIG. 2A. The phase change layer 74 has a p-type semiconductor property, and may be the same material as that of the phase change layer 48 of FIG. 2A. Thus, the phase change layer 74 and a first conductive plug 66 may form a PN junction diode. The phase change layer 74 contacts the first conductive plug 66. A second insulating interlayer 72 is formed on the first insulating interlayer 62, to cover the first interconnection 70 and expose only the upper surface of the upper electrode 76. The second insulating interlayer 72 may be composed of the same material as that of the first insulating interlayer 62. A second interconnection 78 is disposed on the second insulating interlayer 72. The second interconnection 78 is disposed to extend long in the direction crossing the first interconnection 70, preferably, perpendicularly to the first interconnection 70. The second interconnection 78 contacts the upper surface of the upper electrode 76. The second interconnection 78 is used as a bit line.

FIG. 4 illustrates a structure of the PRAM having the equivalent circuit of FIG. 1 according to a third embodiment of the present invention.

Referring to FIG. 4, first and second stack structures S1 and S2 are disposed on a substrate 60. The substrate 60 may be an n-type semiconductor substrate or an n-type doping region of a p-type semiconductor substrate, that is, an n-type well. The first and second stack structures S1 and S2 are spaced from each other. The first stack structure S1 includes a lower electrode contact layer 80, a phase change layer 82, and an upper electrode 84, which are sequentially stacked. The second stack structure S2 includes a first conductive plug 86 and a first interconnection 88, which are sequentially stacked. The material and function of the lower electrode contact layer 80 may be same as those of the first conductive plug 66 of FIG. 3. However, the first conductive plug 66 of FIG. 3 is formed using a chemical vapor deposition method, but the lower electrode contact layer 80 of the first stack structure S1 may be formed using a selective epitaxial growth method. The phase change layer 82 and the upper electrode 84 of the first stack structure S1 are formed using, for example, a CVD method, and materials and functions of the phase change layer 82 and the upper electrode 84 may be respectively same as those of the phase change layer 74 and the upper electrode 76 of FIG. 3. The phase change layer 82 and the lower electrode contact layer 80 of the first stack structure S1 have the same characteristics as that of a PN junction diode. Materials and functions of the first conductive plug 86 and the first interconnection 88 of the second stack structure S2 may be respectively same as those of the conductive plug 68 and the first interconnection 70 of FIG. 3. The first interconnection 88 functions as a word line and a lower electrode.

Then, an insulating interlayer 90 is formed on the substrate 60, to cover the second stack structure S2 and expose only an upper surface of the upper electrode 84 of the first stack structure S1. The insulating interlayer 90 may be same as that of the first insulating interlayer 62 of FIG. 3. A second interconnection 98 is disposed on the insulating interlayer 90, to contact the upper surface of the upper electrode 84 of the first stack structure S1. The second interconnection 98 is used as a bit line, and is disposed to extend long in the direction crossing the first interconnection 88.

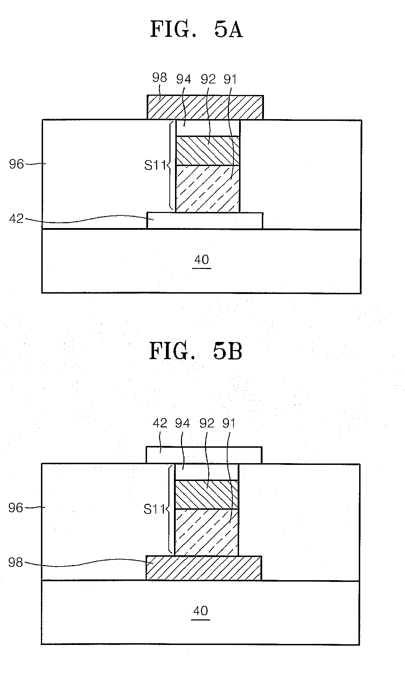

In the meantime, FIGS. 5A and 5B illustrate examples of PRAMs, in which technical characteristics of the PRAM according to the third embodiment of the present invention in FIG. 4 is employed in the PRAM according to the first embodiment of the present invention in FIG. 2A.

Referring to FIG. 5A, a first interconnection 42 functioning as a word line and a lower electrode is disposed on a substrate 40. A stack structure S11 is disposed on the first interconnection 42. The stack structure S11 includes a lower electrode contact layer 91, a phase change layer 92, and an upper electrode contact plug 94, which are sequentially stacked. The lower electrode contact layer 91 may be an n-type silicon layer. The phase change layer 92 may be a phase change material layer showing the same characteristics as that of a p-type semiconductor, for example, a GST layer. The upper electrode contact plug 94 may be, for example, a titanium electrode. An insulating interlayer 96 is formed on the substrate 40 to cover the first interconnection 42 and around the upper electrode contact plug 94 of the stack structure S11 to expose an upper surface of the upper electrode contact plug 94. A second interconnection 98 is formed on the insulating interlayer 96, to contact the upper surface of the upper electrode contact plug 94. The second interconnection 98 is used as a bit line, and is disposed to cross the first interconnection 42 or in parallel with the first interconnection 42.

In the meantime, positions of the first and second interconnections 42 and 98 may be changed to each other as shown in FIG. 5B. Thus, the second interconnection 98 may be disposed between the substrate 40 and the lower electrode contact layer 98. The first interconnection 42 may be disposed on the insulating interlayer 96, to cover the upper electrode contact plug 94. In this structure, the first and second interconnections 42 and 98 may be disposed to cross each other, or in parallel with each other.

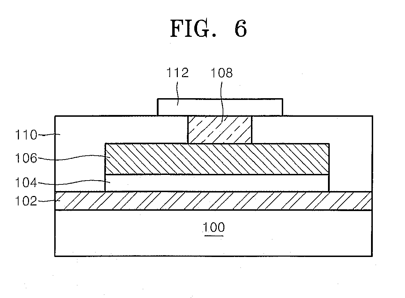

FIG. 6 illustrates a structure of a PRAM having the equivalent circuit of FIG. 1 according to a fourth embodiment of the present invention. The characteristics of the PRAM according to the fourth embodiment of the present invention in FIG. 6 is that positions of a phase change layer and a lower electrode contact layer are changed.

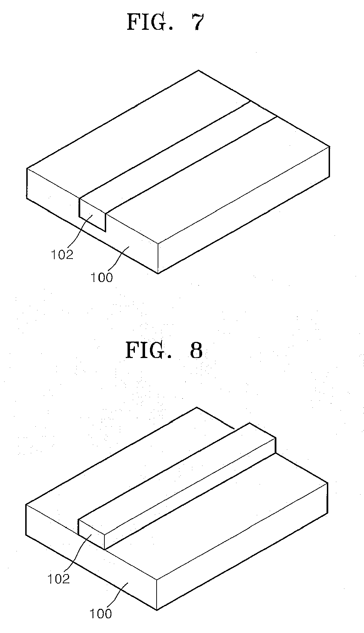

Referring to FIG. 6, a first interconnection 102 is formed on a substrate 100. The first interconnection 102 functions as a bit line. The first interconnection 102 is formed using a damascene process. As shown in FIG. 7, the first interconnection 102 may be buried in the substrate 100, except for its upper surface. Alternatively, the first interconnection 102 may be embossed on a predetermined portion of the substrate 100 as shown in FIG. 8. A first conductive layer 104 is disposed on a predetermined portion of the first interconnection 102. The first conductive layer 104 corresponds to the upper electrodes 50, 76, 84, and 94 of the PRAM according to the first through third embodiments of the present invention. Thus, the first conductive layer 104 may be, for example, a titanium layer. The first conductive layer 104 may extend on the substrate 100.

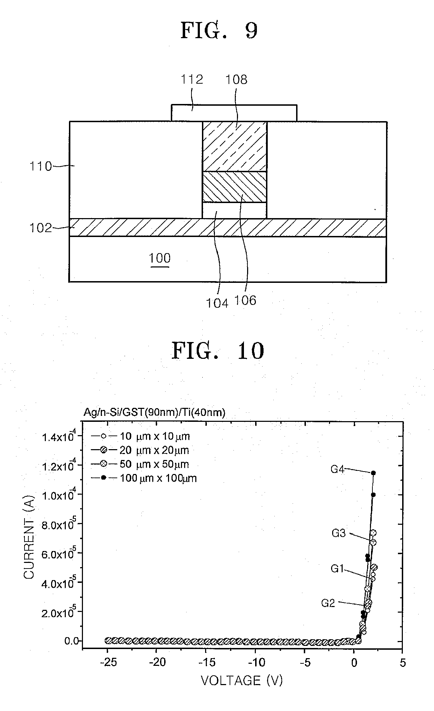

A phase change layer 106 is disposed on the first conductive layer 104. The phase change layer 106 has the same characteristics as that of a p-type semiconductor, and may be, for example, a GST layer. A conductive plug 108 is disposed on a predetermined portion of the phase change layer 106. The conductive plug 108 may be a silicon plug doped with an n-type semiconductor material, for example, n-type impurities, phosphorus P. An insulating interlayer 110 is formed on the substrate 100 to cover the line-shaped first interconnection 102, the first conductive layer 104, the phase change layer 106, and the conductive plug 108 to expose an upper surface of the conductive plug 108. A second interconnection 112 is disposed on the insulating interlayer 110 to contact the upper surface of the conductive plug 108. The second interconnection 112 functions as a word line and an upper electrode, and is disposed to cross the first interconnection 102. Further, the first conductive layer 104, the phase change layer 106, and the conductive plug 108 may have a same diameter as shown in FIG. 9.

Current-voltage characteristics of the stack structure is measured by the inventor of the present invention in order to verify whether the stack structure including the lower electrode contact layer and the phase change layer in the PRAM according to embodiments of the present invention described above shows P-N junction diode characteristics or not. The inventor makes four specimens for this measurement. The four specimens are fabricated to have same composition. The stack structure includes a silver (Ag) layer, an n-type silicon layer, a GST layer (90 nm thickness), and a titanium layer (40 nm thickness), which are sequentially stacked. However, the size (transverse x longitudinal) of the stack structure is made different in each specimen. That is, a size of the stack structure of a first specimen is 10 µm x 10 µm, a size of the stack structure of a second specimen is 20 µm x 20 µm, a size of the stack structure of a third specimen is 50 µm x 50 µm, and a size of the stack structure of a fourth specimen is 100 µm x 100 µm. In the process of fabricating the stack structure of each specimen, a natural oxide layer (SiO₂) may be formed on an n-type silicon layer, but since a thickness of the natural oxide layer is very thin, the natural oxide layer does not influence current-voltage characteristics of the stack structure.

FIG. 10 illustrates current-voltage characteristics measured with respect to the four specimens. In FIG. 10, first through fourth plots (G1 ~ G4) respectively show current-voltage characteristics in the first through fourth specimens. In the current-voltage characteristics measurement, a voltage is applied between an upper electrode and a lower electrode such that a current flows from the upper electrode (Ti layer) to the lower electrode (Ag layer).

Referring to FIG. 10, although current intensities in the four specimens are different in accordance with the sizes of the stack structures in the four groups when an applied voltage exceeds a threshold voltage, it is acknowledged that the first through fourth specimens all show PN-junction diode characteristics.

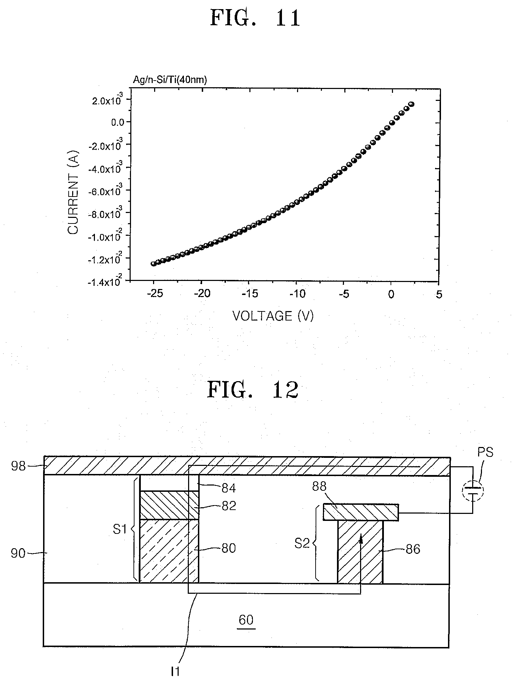

FIG. 11 shows a current-voltage characteristic of the stack structure in the second specimen from which a GST layer as a phase change layer is removed. Comparing FIG. 11 with the second plots (G2) in FIG. 10, it is acknowledged that the plot of FIG. 11 is different from the plot of the PN-junction diode characteristic. The result of FIG. 11 says that the GST layer in the stack structure of the second specimen has the same characteristic as that of a p-type semiconductor. Since the stack structures of the first through fourth specimens are all same in structure, and they all show same PN-junction diode characteristics although their sizes are different from one another, it is acknowledged that current-voltage characteristics of the stack structures in the first, third, and fourth specimens, from which the GST layers are respectively removed, may be same as that of the plot in FIG. 11.

Now, a method of operating the PRAM according to an embodiment of the present invention as described above will be explained. As the base structures of the PRAMs according to the embodiments of the present invention as described above are same, a method of operating the PRAM according to any one embodiment of the present invention, for example, the embodiment of FIG. 4, will be explained, and methods of operating the PRAMs according to other embodiments of the present invention can be explained by the method of operating the PRAM of FIG. 4.

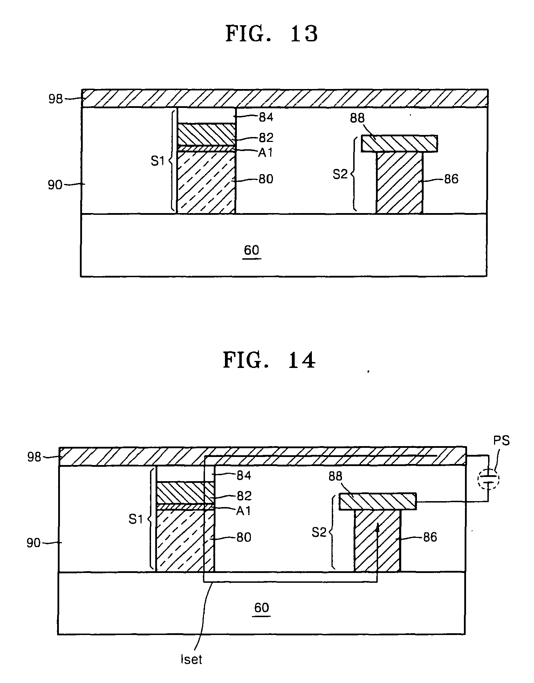

Referring to FIG. 12, a power source PS is connected between a second interconnection 98 used as a bit line, and a first interconnection 88 functioning as a word line and a lower electrode. A negative voltage is applied from the power source PS through the first interconnection 88, the first conductive plug 86, and the substrate 60, to the lower electrode contact layer 80 composed of an n-type semiconductor material, and a positive voltage is applied to the upper electrode 84 through the second interconnection 98. A forward current I1 flows through the first stack structure S1. When the condition of a current applied between the first interconnection 88 and the second interconnection 98 satisfies a reset current condition, since the forward current I1 is higher than the reset current Ireset, a portion of the first stack structure S1 in contact with the lower electrode contact layer 80 of the phase change layer 82 is phase-changed from a crystal state to an amorphous state. Thus, as shown in FIG. 13, the phase change layer 82 of the first stack structure S1 has an amorphous region A1 at all the interface in contact with the lower electrode contact layer 80. Since the amorphous region A1 is formed in the phase change layer 82 as above, a resistance of the first stack structure S1 is higher than that of the first stack structure S1 before the amorphous region A1 is formed. It is considered that data 1 is recorded to the PRAM of the present invention when a resistance of the first stack structure S1 increases. Thus, when a forward current I1 is higher than a reset current Ireset, the applied voltage is a write voltage.

In the meantime, as shown in FIG. 14, when a set current Iset flows in a forward direction to the phase change layer 82 of the first stack structure S1 having the amorphous region A1, the amorphous region A1 in the phase change layer 82 is changed to a crystal region. Thus, since the entire phase change layer 82 has a crystal structure, a resistance of the first stack structure S1 decreases compared to a resistance when the amorphous region A1 exists in the phase change layer 82. As such, it is considered that the process of changing the amorphous region A1 in the phase change layer 82 to a crystal region so as to decrease the resistance of the first stack structure is a process of erasing the data recorded in the PRAM of the present invention. Thus, a voltage applied between the first and second interconnections 88 and 98 so that a set current Iset flows to the first stack structure S1 in a forward direction is an erase voltage.

A read operation in the PRAM of the present invention uses the characteristics that a resistance of the first stack structure S1 is varied whether the amorphous region A1 exists in the phase change layer 82 of the first stack structure S1 or not.

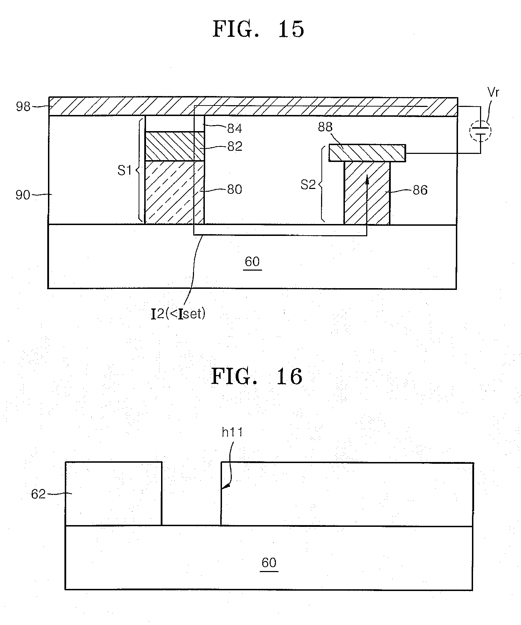

More specifically, referring to FIG. 15, a predetermined read voltage Vr is applied between the first and second interconnections 88 and 98. At this time, a forward current I2 flows to the first stack structure S1, and the forward current I2 is preferably lower than a set current Iset. A resistance of the first stack structure S1 is measured by flowing a forward current I2 to the first stack structure S1. Then, the measured resistance is compared to a reference resistance. The reference resistance has an intermediate value between a resistance of the first stack structure S1 when an amorphous region exists in the phase change layer 82, and a resistance of the first stack structure S1 when an amorphous region does not exist in the phase change layer 82. Thus, when the measured resistance is lower than the reference resistance, it is considered that data 0 is read as the amorphous region does not exist in the phase change layer 82. On the contrary, when the measured resistance is higher than the reference resistance, it is considered that data 1 is read as the amorphous region exists in the phase change layer 82.

Then, a method of fabricating a PRAM according to an embodiment of the present invention will be explained.

Referring to FIG. 16, a first insulating interlayer 62 is formed on a substrate 60. The substrate 60 is be an n-type semiconductor substrate. Further, an n-well formed by doping a p-type semiconductor substrate with n-type impurities, for example, phosphorus can be used for the substrate 60. A first contact hole h11 is formed in the first insulating interlayer 62 to expose the substrate 60, using a photolithography process and an etch process.

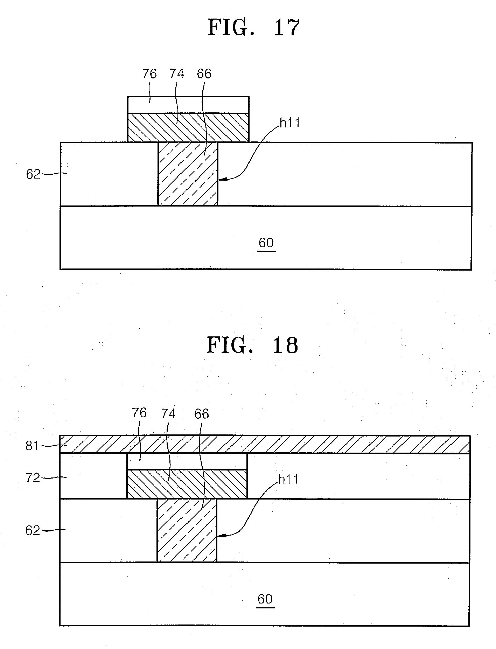

Referring to FIG. 17, the first contact hole h11 is filled with a first conductive plug 66. The first conductive plug 66 may be composed of an n-type semiconductor material, for example, an n-Si. A phase change layer 74 and an upper electrode 76 are sequentially formed on the first insulating interlayer 62, to cover an exposed portion of the first conductive plug 66. The phase change layer 74 and the upper electrode 76 may be formed by sequentially stacking respective formation material layers, and etching the respective formation material layers in a reverse order, using a mask defining a shape of the phase change layer 74, and removing the mask. The phase change layer 74 has a p-type semiconductor material characteristic, and may be formed of, for example, a Ge₂Sb₂Te₅ layer, a GeSb₂Te₄ layer, a Te-Ge-Sn-Au layer, a GeTe-Sb₂Te₃ layer, an In₃SbTe₂ layer, a GeTe-Sb₂Te₃-Sb layer, a Ge-Sb-Te-Pd layer, a Ge-Sb-Te-Co layer or a Sb₂Te₃-Bi₂Se₃ layer. The phase change layer 74 may be formed using a CVD process or other methods. The upper electrode 76 may be a metal electrode, for example, a titanium electrode.

Referring to FIG. 18, a second insulating interlayer 72 is formed on the first insulating interlayer 62, to cover the phase change layer 74 and the upper electrode 76, and the second insulating interlayer 72 is planarized, using a CMP process or other polishing methods. The planarization process is performed until the upper electrode 76 is exposed. The second insulating interlayer 72 may be composed of the same material as that of the first insulating interlayer 62. After the planarization process, a conductive layer (not shown) is formed on the second insulating interlayer 72. The conductive layer is patterned in a line shape, using a photolithography process and an etch process. As a result, a bit line 81 is formed on the second insulating interlayer 72.

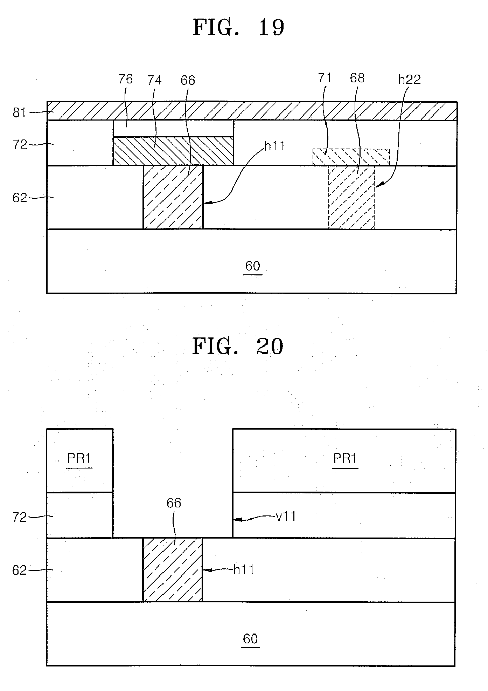

Then, referring to FIG. 19, a second contact hole h22 is formed to be spaced from the first contact hole h11 of the first insulating interlayer 62, to expose the substrate 60. The second contact hole h22 is filled with a second conductive plug 68. The second conductive plug 68 may be composed of a doped silicon or metal. A conductive line 71 is formed on the first insulating interlayer 62, to cover an exposed portion of the second conductive plug 68. At this time, the conductive line 71 is formed in the direction crossing the bit line 81. The conductive line 71 is used as a word line and a lower electrode. The conductive line 71 corresponds to the first interconnection 70 of FIG. 3, and the bit line 81 corresponds to the second interconnection 78.

In the meantime, since the second contact hole h22, the second conductive plug 68, and the conductive line 71 are formed back or front of the sectional view of FIG. 19, although not shown in the sectional view of FIG. 19, they are illustrated in dotted lines for convenience.

Alternatively, after the first contact hole h11 of the first insulating interlayer 62 is filled with the first conductive plug 66, a second via hole h22 is formed in the first insulating interlayer 62 with a portion covering the first contact plug 66 masked, and the second contact hole h22 is filled with the second conductive plug 68.

Further, the phase change layer 74 and the upper electrode 76 may be formed, using other method than the method described above, for example, a damascene process.

As shown in FIG. 20, a photoresistive layer pattern PR1 defining a portion for the phase change layer 74 to be formed is formed in the second insulating interlayer 72. The second insulating interlayer 72 is etched, using the photoresistive layer pattern PR1 as an etch mask. The etch is performed until the first conductive plug 66 is exposed. As a result of the etch, a via hole v11 is formed in the second insulating interlayer 72, to expose an upper surface of the first conductive plug 66, and expose a portion of the second insulating interlayer 72 around the first conductive plug 66.

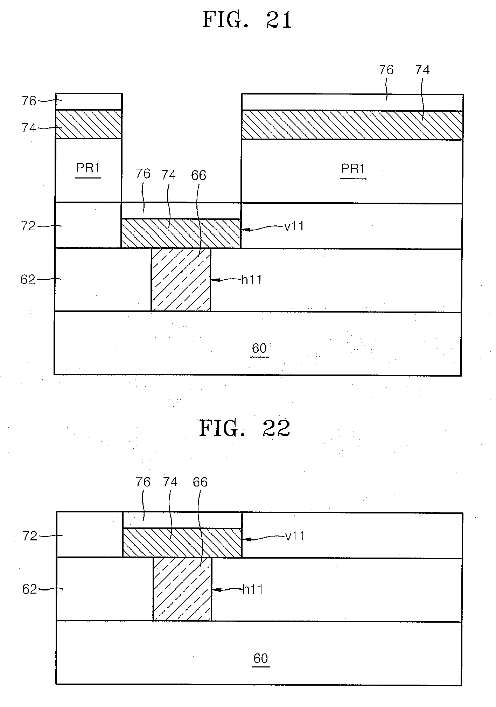

Referring to FIG. 21, a portion of the via hole v11 is filled with the phase change layer 74 at a predetermined height. During the process, the phase change layer 74 may be also formed on the photoresistive layer pattern PR1. Then, a rest portion of the via hole v11, which is filled with the phase change layer 74, is filled with an upper electrode 76. At this time, the upper electrode 76 is also formed on the phase change layer 74, which is formed on the photoresistive layer pattern PR1. Then, the photoresistive layer pattern PR1 is removed. While the photoresistive layer pattern PR1 is removed, the phase change layer 74 and the upper electrode 76, which are formed on the photoresistive layer pattern PR1, are also removed. As a result, as shown in FIG. 22, the via hole v11 is filled by sequentially stacking the phase change layer 74 and the upper electrode 76. Subsequent processes are same as described in reference to FIGS. 18 and 19.

Then, a method of fabricating the PRAM according to an embodiment of the present invention in FIG. 4 will be explained.

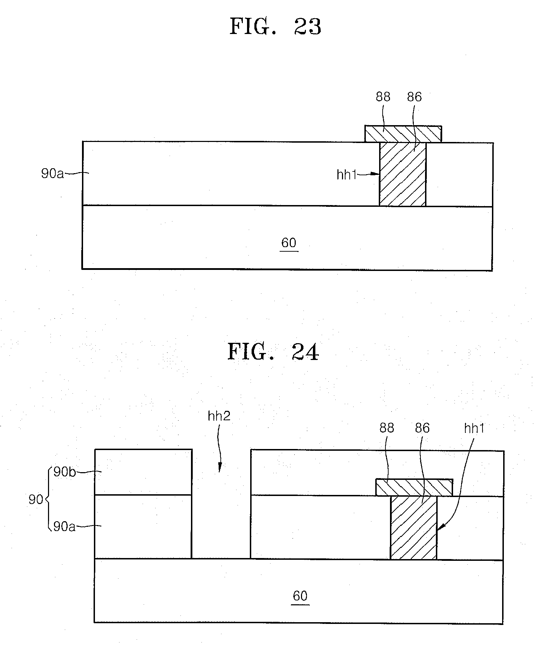

Referring to FIG. 23, a first insulating interlayer 90a is formed on the substrate 60. A first contact hole hh1 is formed in the first insulating interlayer 90a, to expose the substrate 60. The first contact hole hh1 is filled with a first conductive plug 86. The first conductive plug 86 may be formed of a doped silicon layer or a conductive layer. A first interconnection 88 is formed on the first insulating interlayer 90a, to cover the first conductive plug 86. The first interconnection 88 may be used as a word line and a lower electrode.

Then, referring to FIG. 24, a second insulating interlayer 90b is formed on the first insulating interlayer 90a, to cover the first interconnection 88. A second contact hole hh2 is formed in the insulating interlayer 90, which includes the first and second insulating interlayers 90a and 90b, to expose the substrate 60.

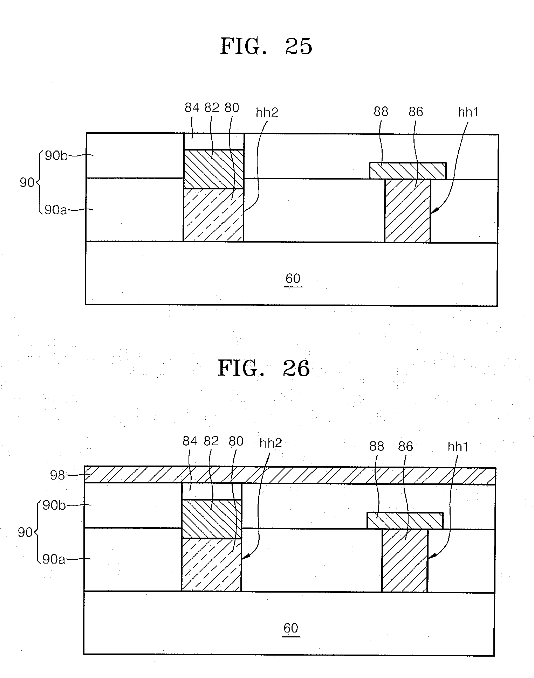

Then, referring to FIG. 25, a portion of the second contact hole hh2 is filled with a lower electrode contact layer 80, at a predetermined height. At this time, the lower electrode contact layer 80 may be an n-type silicon layer grown only on the substrate 60 exposed through the second contact hole hh2, using a selective epitaxial growth method. The n-type silicon layer may be formed by doping n-type impurities, for example, phosphorus (P) during the process of growing the silicon layer using the selective epitaxial growth method. After a portion of the second contact hole hh2 is filled with the lower electrode contact layer 80 as above, a rest portion of the second contact hole hh2 is filled by sequentially stacking the phase change layer 82 and the upper electrode 84. The phase change layer 82 and the upper electrode 84 may be formed using a CVD method. After the second contact hole hh2 is filled, a second interconnection 98 is formed on the insulating interlayer 90 as shown in FIG. 26. The second interconnection 98 is used as a bit line, and is preferably formed to cross the first interconnection 88.

The PRAM according to an embodiment of the present invention of FIGS. 2A and 5A is fabricated by forming the first interconnection 88 between the substrate 60 and the lower electrode contact layer 80, and using the first interconnection 88 as a word line and a lower electrode, instead of forming the first conductive plug 86 and the first interconnection 88.

In the meantime, the PRAM according to an embodiment of the present invention of FIGS 6 and 9 may be formed using the same processes according to other embodiment of the present invention except for forming a bit line below a word line, and forming the phase change layer below the lower electrode contact layer.

Further, in the many PRAMs according to embodiments of the present invention as described above, a phase change material showing n-type semiconductor characteristics, for example, In-S, Ti-In-S, and Ge-Bi-Te may be used for the phase change layers 48, 74, 82, 92, and 106, instead of using the phase change material showing p-type semiconductor characteristics, for example, GST. At this time, the lower electrode contact layers 46, 66, 80, 90 and 108 of the PRAMs of the present invention as described above may be composed of a semiconductor material doped with p-type impurities, for example, p-Si. Further, at this time, an applied voltage for operation is applied reversely to the above. That is, a negative voltage is applied to the phase change layer, and a positive voltage is applied to the lower electrode contact layers.

Further, in the PRAMs and the methods of fabricating the same according to embodiments of the present invention as described above, a doping density of a lower electrode contact layer may be provided variously in accordance with regions. For example, an impurity doping density may be provided to sequentially increase or decrease from a bottom end of the lower electrode contact layer to a top end thereof, or from a top end to a bottom end. The present invention has been described specifically as above, but it must be understood that the embodiments of the present invention are exemplary embodiments rather than limiting the scope of the present invention. For example, the phase change layer or the lower electrode contact layer may be formed using other materials than the materials described above by those skilled in this art. Further, an operation current can be decreased by reducing sizes of the elements while keeping the same technical spirit of the present invention. Further, a material layer may be further provided between the substrate and the lower electrode contact layer, or between the upper electrode and the bit line to decrease a contact resistance.

As described above, since the phase change layer in the PRAM of the present invention has a p-type semiconductor material characteristic or a n-type semiconductor material characteristic, the stack structure including the phase change layer is a resistance element and also has a diode function. Therefore, since a separate switching element (for example, transistor or diode) for controlling current flow is not necessary when the PRAM of the present invention is used, the structure of the PRAM can be simplified. Therefore, fabrication processes of the PRAM are simplified, and an integration density thereof can be increased.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A phase change RAM (PRAM) comprising:
a substrate;
a phase change diode layer formed on the substrate; and
an upper electrode formed on the phase change diode layer.

2. The PRAM of claim 1, wherein the phase change diode layer comprises:
a material layer doped with first impurities, and a phase change layer, which are sequentially stacked, wherein the phase change layer shows a characteristic of a semiconductor material doped with impurities having an opposite conductive type to that of the first impurities.

3. The PRAM of claim 2, wherein the first impurities are n-type impurities, and the phase change layer is composed of a phase change material showing a p-type semiconductor material characteristic.

4. The PRAM of claim 2 or 3, wherein a width of the phase change layer is greater than a width of the material layer doped with first impurities.

5. The PRAM of any preceding claim, further comprising:
a word line disposed between the phase change diode layer and the substrate; and
a bit line disposed on the upper electrode to contact the upper electrode and to cross the word line.

6. The PRAM of any of claims 1 to 4, further comprising:
a word line disposed on the substrate spaced from the phase change diode layer: and
a bit line disposed on the upper electrode to contact the upper electrode and to cross the word line.

7. The PRAM of claim 1, wherein the phase change diode layer comprises:
a phase change layer and a material layer doped with first impurities, which are sequentially stacked, in which the phase change layer is composed of a phase change material showing a characteristic of a semiconductor material doped with impurities having an opposite conductive type to that of the first impurities.

8. The PRAM of claim 7, wherein the first impurities are n-type impurities, and the phase change layer is composed of a phase change material showing a p-type semiconductor material characteristic.

9. The PRAM of claim 7 or 8, further comprising:
a bit line disposed between the phase change diode layer and the substrate; and
a word line disposed on the upper electrode to contact the upper electrode and to cross the bit line.

10. The PRAM of claim 7 or 8, further comprising:
a bit line disposed on the substrate spaced from the phase change diode layer.

11. The PRAM of any of claims 7 to 10, wherein a width of the phase change layer is greater than a width of the material layer doped with first impurities.

12. The PRAM of any preceding claim, wherein the substrate is an n-type or a p-type semiconductor substrate.

13. The PRAM of any of claims 1 to 12, wherein the substrate is a non-semiconductor substrate.

14. The PRAM of claim 2 or 7, wherein the first impurities are p-type impurities, and the phase change layer is composed of a phase change material showing a n-type semiconductor material characteristic.

15. A method of operating a PRAM having a phase change diode layer between a substrate and an interconnection, the method comprising applying a current passing the phase change diode layer between the substrate and the interconnection in a forward direction.

16. The method of claim 15, wherein the applying of the current comprises applying a write current.

17. The method of claim 15, wherein the applying of the current comprises applying a read current.

18. The method of claim 15, the applying of the current comprises applying an erase current.

19. The method of claim 17, wherein the applying of the read current comprises:
applying the read current to measure a resistance of the phase change diode layer; and
comparing the measured resistance to a reference resistance.

20. The method of any of claims 15 to 19, wherein the phase change diode layer comprises a material layer doped with first impurities and a phase change layer, which are sequentially stacked, wherein the phase change layer is composed of a phase change material showing a characteristic of a semiconductor material doped with impurities having an opposite conductive type to that of the first impurities.

21. The method of any of claims 15 to 19, wherein the phase change diode layer comprises a phase change layer and a material layer doped with first impurities, which are sequentially stacked, wherein the phase change layer is composed of a phase change material showing a characteristic of a semiconductor material doped with impurities having an opposite conductive type to that of the first impurities.

22. The method of any of claims 15 to 21, wherein other interconnection is further provided between the substrate and the phase change diode layer, and the current is applied between the interconnection and the other interconnection.

23. The method of any of claims 15 to 21, wherein other interconnection is further provided on a predetermined portion of the substrate spaced from the phase change diode layer, and the current is applied between the interconnection and the other interconnection.

24. The method of claim 20 or 21, wherein other interconnection is further provided between the substrate and the phase change diode layer, and the current is applied between the interconnection and the other interconnection.

25. The method of claim 20 or 21, wherein other interconnection is further provided on a predetermined portion of the substrate spaced from the phase change diode layer, and the current is applied between the interconnection and the other interconnection.

26. A method of fabricating a PRAM comprising:
forming a first interconnection on a substrate doped with first impurities;
forming a first insulating interlayer on the substrate to cover the first interconnection;
forming a contact hole in the first insulating interlayer to expose a predetermined portion of the substrate spaced from the first interconnection;
filling the contact hole with a material layer doped with first impurities;
sequentially stacking a phase change layer and an upper electrode on the first insulating interlayer to cover the doped material layer, the phase change layer showing a semiconductor characteristic opposite to that of the doped material layer; and
forming a second interconnection connected to the upper electrode and crossing the first interconnection.

27. The method of claim 26, wherein the sequentially stacking comprises:
forming a second insulating interlayer on the first insulating interlayer to cover the doped material layer;
forming a photoresistive layer pattern on the second insulating interlayer defining a portion where the phase change layer is formed;
forming a via hole exposing the doped material layer in the second insulating interlayer, using the photoresistive layer pattern as a mask;
sequentially stacking the phase change layer and the upper electrode in the via hole; and
removing the photoresistive layer pattern.

28. The method of claim 26 or 27, wherein the first impurities are n-type impurities, and the phase change layer is composed of a phase change material showing a p-type semiconductor material characteristic.

29. A method of fabricating a PRAM comprising:
forming a first interconnection on a substrate doped with first impurities;
forming an insulating interlayer on the substrate to cover the first interconnection;
forming a contact hole in the insulating interlayer to expose a predetermined portion of the substrate spaced from the first interconnection;
sequentially stacking a material layer doped with the first impurities, a phase change layer showing semiconductor characteristics opposite to that of the doped material layer, and an upper electrode in the contact hole; and
forming a second interconnection on the insulating interlayer, the second interconnection connected to the upper electrode and crossing the first interconnection.

30. The method of claim 29, wherein the first impurities are n-type impurities, and the phase change layer is composed of a phase change material showing a p-type semiconductor material characteristic.

31. The method of claim 29 or 30, wherein the material layer doped with the first impurities, and the phase change layer are formed using different methods.

32. The method of claim 29 or 30, wherein the material layer doped with the first impurities is formed using a selective epitaxial growth method.

33. A method of fabricating a PRAM comprising:
forming a first interconnection on a substrate;
forming an insulating interlayer on the substrate to cover the first interconnection;
forming a contact hole in the insulating interlayer to expose a portion of the first interconnection;
forming a conductive layer, a phase change layer and a material layer doped with first impurities in the contact hole; and
forming a second interconnection connected to the doped material layer and crossing the first interconnection on the insulating interlayer, wherein the phase change layer is composed of a phase change material showing semiconductor characteristics opposite to that of the doped material layer.

34. The method of claim 33, wherein the first interconnection is formed to be buried in the substrate or embossed on the substrate.

35. A method of fabricating a PRAM comprising:
forming a first interconnection on a substrate doped with first impurities;
forming an insulating interlayer on the substrate to cover the first interconnection;
forming a contact hole in the insulating interlayer to expose a portion of the substrate spaced from the first interconnection;
sequentially forming a phase change layer and a material layer doped with second impurities having a conductive type opposite to that of the first impurities in the contact hole; and
forming a second interconnection connected to the doped material layer and crossing the first interconnection on the insulating interlayer, wherein the phase change layer is composed of a phase change material showing the same semiconductor characteristics as that of the substrate.

36. The method of claim 35, further comprising forming a conductive layer between the substrate and the phase change layer.

37. The method of claim 35, further comprising forming a conductive plug between the first interconnection and the substrate.
